# FASCICULE DE BREVET EUROPEEN

(11) **EP 2 745 662 B1**
(45) Date de publication et mention de la délivrance du brevet: **22.07.2015**
(21) Numéro de dépôt: 12758537.0
(22) Date de dépôt: 25.07.2012
(51) Int. Cl.: H05K 7/14, H05K 7/02, B60L 11/18, H02M 7/00, H05K 1/18

(54) **BLOC DE PUISSANCE POUR ONDULEUR DE VEHICULE ELECTRIQUE, ONDULEUR ET VÉHICULE ÉLECTRIQUE COMPRENANT CE BLOC**
LEISTUNGSBLOCK FÜR EINEN WECHSELSTROMUMRICHTER, WECHSELSTROMUMRICHTER UND ELEKTRISCHES FAHRZEUG UMFASSEND EINEN SOLCHEN LEISTUNGSBLOCK
POWER UNIT FOR AN ELECTRIC VEHICLE INVERTER, INVERTER AND ELECTRIC VEHICLE INCLUDING SAID UNIT

(30) Priorité: 19.08.2011 FR 1157417
(43) Date de publication de la demande: 25.06.2014
(73) Titulaire: Valeo Systèmes de Contrôle Moteur, 95800 Cergy (FR)
(72) Inventeur: TRAMET, Guillaume, F-78360 Montesson (FR); DENIOT, Roger, F-78300 Poissy (FR); MORLIERE, Benjamin, F-95520 Osny (FR); HERAULT, Fabrice, F-78410 Flins sur Seine (FR)
(86) Numéro de dépôt international: PCT/FR2012/051766
(87) Numéro de publication internationale: WO 2013/026969

(56) Documents cités:
- EP-A1- 2 328 265
- DE-A1- 10 161 016
- FR-A1- 2 833 802
- FR-A1- 2 871 022
- FR-A1- 2 914 531
- US-A- 6 147 869
- US-A1- 2007 284 947

## Description

La présente invention se rapporte à un bloc de puissance, notamment pour un onduleur, en particulier monté aux bornes d'une batterie à haute tension d'un véhicule électrique, qui comporte au moins un module électronique de puissance, de préférence une pluralité de modules de puissance, relié(s) à au moins une carte électronique de commande.

On connaît déjà dans l'art antérieur des modules de puissance destinés à faire partie d'un tel bloc de puissance, notamment des modules de puissance à Grille de connexion Moulée Isolée ou module IML (pour « Insulated Moulded Leadframe » en anglais) du brevet français N° 0116153 au nom de la demanderesse. La carte électronique de commande est typiquement une carte PCB ou à circuits imprimés. Le module de puissance et la carte électronique de commande sont connectés électriquement afin d'assurer les fonctions du bloc de puissance. Typiquement, le module et la carte sont logés dans un carter du bloc de puissance.

Typiquement, les connecteurs électriques entre le module de puissance et la carte électronique de commande sont soudés sur la carte par un procédé de vague à l'étain connu en soi. Cependant, il s'agit d'un procédé difficile à mettre en oeuvre. En effet, l'ensemble, constitué par le module de puissance et la carte électronique de commande, doit être retourné pour être mis en contact avec une source d'étain appelée vague. En outre, une qualité de la soudure est difficile à atteindre du fait de la faible adhérence de l'étain sur une surface. Or, une mauvaise qualité de la soudure diminue la durée de vie de la connexion électrique, ce qui est particulièrement préjudiciable notamment dans le cadre du développement d'un véhicule électrique

On connaît d'autres procédés de soudage tels que le brasage par refusion électrique ou le soudage par ultrasons. Dans ces procédés, il est nécessaire d'assurer un maintient de la carte électronique de commande durant le procédé de soudage.

A cet effet, le bloc de puissance peut comprendre des plots verticaux issus du fond du carter pour supporter la carte. Cependant, celle-ci manque de rigidité entre les plots, ce qui a pour effet de nuire à la bonne qualité de la soudure des connexions électriques entre la carte et le module électronique de puissance, en particulier pour une soudure par ultrason.

Le document US-A-6147869 décrit un module de puissance avec une carte de commande qui repose sur des ergots ou saillies d'un carter.

Le document EP-A1-2328265 décrit un module de puissance positionné sur un plan d'un carter, avec une carte de commande qui repose sur la partie supérieure des parois latérales dudit carter.

Le document US-A1-2007/284947, considéré comme l'état de la technique le plus proche de l'objet de la revendication 1, décrit un module de puissance positionné sur un plan d'un carter, avec une carte de commande qui repose dans un entaille dudit carter. Cette entaille peut s'étendre, p.e., sur la circonférence intérieure du carter et est destinée à recevoir les bords de la carte de commande. Il en résulte que la carte est supportée par un organe qui s'étend sur au moins une étendue de la carte.

Il est donc recherché un bloc de puissance permettant un maintien rigide de la carte électronique de commande.

Suivant l'invention, il est proposé un bloc de puissance selon la revendication 1 ayant un carter dans lequel est reçu au moins un module électronique de puissance, de préférence une pluralité de modules de puissance, positionné sur un plan du carter, le ou chaque module électronique de puissance comportant au moins un composant électronique de puissance, et étant connecté à au moins une carte électronique de commande par l'intermédiaire d'au moins un élément de connexion, ledit bloc comprenant au moins un organe supportant la au moins une carte électronique de commande en vis-à-vis du module de puissance sur au moins une étendue de la carte. L'organe de support est une poutre sensiblement parallèle audit plan du carter.

Jusqu'à maintenant, le bloc de puissance était peu fiable. Les inventeurs se sont rendu compte que cela était dû à la mauvaise connexion électrique entre les modules de puissance et la carte électronique de commande, et notamment à la difficulté de réaliser la soudure des éléments de connexion électrique à la carte. L'organe de support de la carte électronique supporte la carte sur au moins une étendue de la carte. Dans le cadre de la présente demande, une étendue désigne une dimension de la carte, telle que par exemple une largeur, une longueur ou une diagonale de la carte. Ainsi, la carte étant supportée sur au moins une de ses dimensions, un maintien rigide de la carte est assuré par l'organe de support. Une pression peut être réalisée sur la carte pour obtenir une connexion des éléments de connexion sur la carte électronique sans l'occurrence d'une déformation qui diminuerait la qualité de la connexion électrique. Notamment, l'organe de support permet de maintenir la carte, pendant une soudure, ou lors d'une mise en prise en force des éléments de connexion électrique. L'organe de support maintient la carte en regard du module de puissance, en particulier au dessus du module de puissance.

Le module de puissance comprend un ou plusieurs composants électroniques de puissance qui reçoivent des signaux électriques de puissance élevée. Dans le cadre de la présente demande, un composant électronique de puissance désigne un composant seul ou un ensemble de sous-composants. Le composant électronique est apte à transmettre un signal électrique ayant une puissance comprise par exemple entre 40 et 100 kW. La carte électronique de commande comprend des composants recevant des signaux de puissance faible. Notamment, la carte électronique de commande contrôle l'électronique du module de puissance.

De préférence, l'élément de connexion est soudé à la carte de commande par ultrason, ce qui est très avantageux car ce type de soudure peut être réalisé à grande vitesse.

Suivant un mode de réalisation préféré de l'invention, l'élément de connexion entre le au moins un module de puissance et la au moins une carte électronique de commande est constitué d'au moins un fil de liaison électrique (« bonding » en anglais).

Suivant un mode de réalisation préféré de l'invention, l'élément de connexion est une broche reliée électriquement au module de puissance et à la carte électronique de commande. Par exemple, la connexion électrique de la carte est réalisée en partie par une mise en force de la broche dans une ouverture de la carte.

Suivant un mode de réalisation préféré de l'invention, le plan du carter est un fond du carter.

Suivant un mode de réalisation préféré de l'invention, l'organe de support est fixé au carter du bloc de puissance.

En particulier, l'organe de support est supporté par une ou des parois latérales du carter.

Suivant un mode de réalisation préféré de l'invention, la carte électronique de commande est fixée à l'organe de support par au moins un organe de fixation, de préférence une vis de fixation. L'organe de fixation peut être tout élément permettant une solidarisation mécanique entre la carte électronique de commande et l'organe de support.

De préférence, le bloc de puissance comprend au moins un organe de fixation en vis-à-vis du module de puissance. En particulier, le bloc de puissance comprend deux organes de fixation en vis-à-vis du module de puissance. Dans un exemple particulier, l'élément de connexion connecte la carte entre lesdits deux organes de fixation.

Par exemple, on prévoit deux vis de fixation en vis-à-vis de chaque module et une zone de soudure de fils de liaison électrique d'un module est définie par la région de la carte qui se trouve au-dessus de la poutre entre les deux vis associées au dit module.

Le fait de prévoir ainsi au moins un organe de fixation en vis-à-vis de chaque module, et notamment deux organes de fixation en vis-à-vis de chaque module, assure une excellente rigidité de la surface de la carte sur laquelle est effectuée la connexion électrique des éléments de connexion. Notamment, ceci assure la rigidité de la carte électronique de commande lors d'une soudure à ultrason des éléments de connexion électrique sur la carte électronique de commande.

Suivant un mode de réalisation préféré de l'invention, l'organe de support comprend une première matière rigide s'étendant dans l'organe de support. La première matière assure un maintien rigide de la carte électronique. Notamment, la première matière rigide est un métal.

Dans une variante de ce mode de réalisation, une seconde matière isolante électriquement recouvre au moins une partie de ladite première matière rigide. En particulier, la seconde matière isolante est localisée au moins entre la première matière et la carte électrique de commande. En particulier, la seconde matière isolante enrobe la première matière. La seconde matière améliore l'isolation électrique de la carte électronique de commande avec l'organe de support. Notamment, la seconde matière isolante électriquement est un plastique.

En particulier, la seconde matière est surmoulée sur la première matière de l'organe de support.

Suivant un mode de réalisation préféré de l'invention, l'organe de fixation pénètre dans un trou formé dans la première matière de l'organe de support, le trou étant rempli de la seconde matière électriquement isolante. Suivant un mode de réalisation préféré de l'invention, la flèche de l'organe de support est inférieure à 0,1 mm lorsque l'organe de support subit une contrainte transverse, voire suivant une direction sensiblement orthogonale, comprise entre 1 et 2 kg, notamment sensiblement égale à 1,5 kg, et est soumis à des ultrasons de fréquence comprise entre 50 et 100 kHz, notamment sensiblement égale à 80 kHz. Ainsi, les éléments de connexion électrique peuvent être connectés sur la carte électronique de commande par une soudure par ultrasons.

La présente invention se rapporte également à un onduleur, notamment pour un véhicule électrique, comportant un bloc de puissance suivant l'invention.

La présente invention se rapporte également à un véhicule électrique comportant un bloc de puissance suivant l'invention relié à une batterie haute tension du véhicule électrique en vue de recharger la batterie à partir d'une prise d'un secteur électrique.

L'invention concerne en outre un bloc de puissance ayant un carter dans lequel est reçu au moins un module électronique de puissance, de préférence une pluralité de modules de puissance, positionné sur un plan du carter, le ou chaque module électronique de puissance comportant au moins un composant électronique de puissance, et étant connecté à au moins une carte électronique de commande par l'intermédiaire d'au moins un élément de connexion, caractérisé en ce qu'il comprend au moins un organe supportant la au moins une carte électronique de commande en vis-à-vis du module de puissance sur au moins une étendue de la carte, l'organe de support étant une poutre sensiblement parallèle audit plan du carter.

On décrit maintenant à titre d'exemple des modes de réalisation de l'invention en se rapportant aux dessins dans desquels :
- la figure 1: est une vue en perspective éclatée de dessus d'un bloc de puissance suivant un mode de réalisation de l'invention, la carte électronique de commande étant représentée à l'état non fixée aux organes de support ;
- la figure 2: est une vue en coupe suivant la ligne AA de la figure 1 ; la carte électronique étant fixée aux organes de support et connectée aux modules de puissance ;
- la figure 3: est une vue en coupe d'un bloc de puissance selon un mode de réalisation de l'invention, dans lequel les modules de puissance ne sont pas représentés ;
- la figure 4: est une autre vue en coupe d'une partie d'un bloc de puissance selon un mode de réalisation de l'invention ;
- la figure 5: est un schéma synoptique d'un véhicule électrique comportant un onduleur comprenant un bloc de puissance selon un mode de réalisation de l'invention ; et
- la figure 6: est une vue en perspective d'un module d'un bloc de puissance selon un mode de réalisation de l'invention.

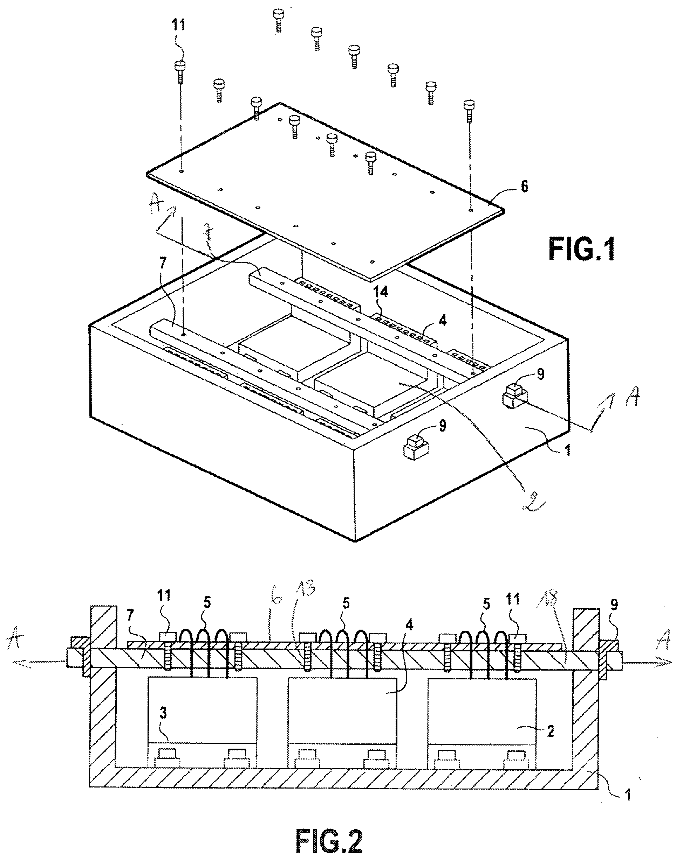

Aux figures 1 à 4, il est représenté des exemples de bloc de puissance suivant l'invention comprenant un carter 1 de forme sensiblement parallélépipédique.

Le carter 1 reçoit un ou plusieurs modules de puissance 2. Dans l'exemple illustré en figure 1, le carter 1 reçoit six modules 2 électroniques de puissance qui sont disposés suivant deux rangées de trois modules. Une carte 6 électronique de commande s'étend en vis-à-vis des modules 2.

La carte 6 électronique de commande s'étend en vis-à-vis des modules 2 en y étant reliée par des éléments de connexion électrique, tels que des fils 5 de liaison électrique (figure 2). La carte électronique de commande est par exemple une carte PCB ou à circuit imprimé qui est disposée au-dessus des modules de puissance 2.

La carte 6 électronique de commande est supportée par deux poutres de support 7, 8 s'étendant de part et d'autre du carter 1. Les poutres 7, 8, ont une section de forme carrée, mais qui pourrait également avoir une autre forme. Les organes de support, ici les poutres de support 7, 8 sont fixés à la fonderie du carter 1 par un organe de fixation tel qu'une vis 9.

La poutre de support 7, 8 comprend une première matière 18 rigide qui s'étend dans la poutre de support 7, 8. La première matière rigide est par exemple un métal comme l'acier ou l'aluminium par exemple. Par exemple, la poutre de support 7 est constituée de la première matière 18 comme illustré en figure 2. La poutre de support 8 peut comprendre en outre une seconde matière 19 isolante électriquement. La seconde matière isolante 19 recouvre au moins une partie de la première matière 18 améliorant ainsi l'isolation électrique de la carte électronique de commande 6 avec la poutre de support 8. Par exemple, la seconde matière 19 est un plastique surmoulé sur la première matière 18.

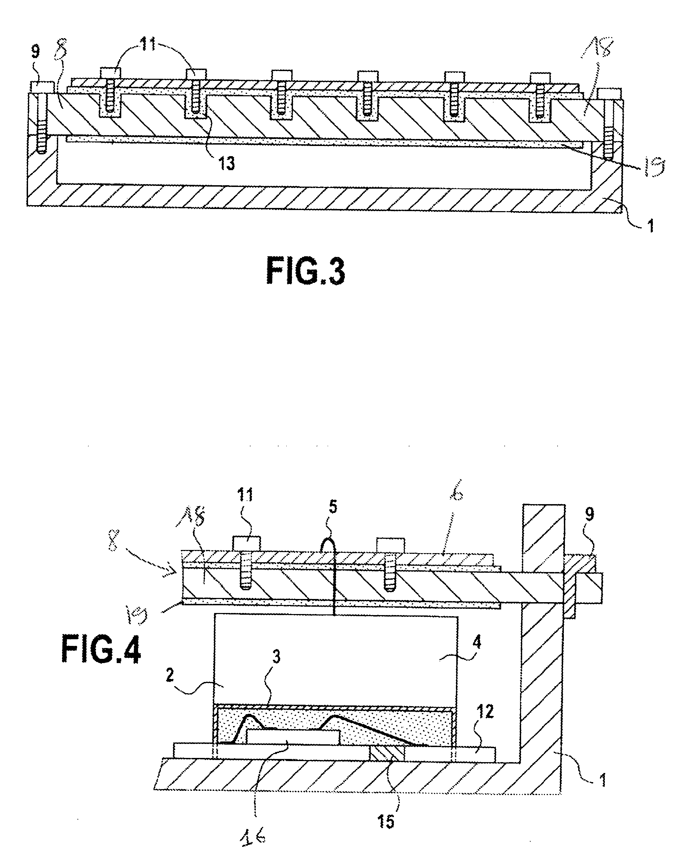

La carte 6 électronique de commande peut être fixée à chaque poutre 7, 8 par une série de vis 11 de fixation. De préférence, chaque vis 11 de fixation pénètre dans un trou 13 respectif formé dans la poutre de support 7, 8. Notamment, comme illustré en figure 2, chaque vis 11 peut pénétrer dans un trou 13 formé dans la première matière 18. Le trou 13 peut en outre être rempli de la seconde matière 19 isolante électriquement comme illustré en figure 3. Ainsi, on améliore l'isolation électrique de la carte électronique 6 de commande.

De manière préférable, il est prévu deux vis 11 de fixation délimitant entre elles une zone de la poutre de support 7, 8 et une zone correspondante de la carte 6 au-dessus de chacun des modules 2 (comme illustré en figures 2 et 4). Sur la zone de la carte 6 sont connectés des éléments de connexion 5 prévus pour la connexion électrique entre la carte 6 et chaque module 2. Les éléments de connexion sont par exemple des fils 5 de liaison électrique, comme illustrés en figures 2 et 4, soudés à la carte 6 par ultrason par exemple.

En particulier, les deux vis 11 respectives au-dessus de chaque module 2 peuvent être à une distance l'une de l'autre qui correspond sensiblement à la dimension de chaque module 2 dans la direction d'extension des poutres 7, 8. Par exemple, les vis 11 de fixation sont espacées de la largeur du module 2. En prévoyant ainsi ces deux vis 11 de fixation disposées sensiblement à une distance l'une de l'autre qui correspond à la dimension en largeur de chaque module 2, on donne à la zone correspondante de la carte 6 une rigidité entre les deux vis 11 qui est particulièrement adaptée pour permettre une soudure à ultrason des fils 5 tout en permettant une pluralité de connexions électriques dans la zone de la carte. Ainsi, plusieurs fils 5 de liaison électrique sont fixés à la carte électronique 6 de commande par soudure par ultrason de manière fiable, en particulier dans la zone délimitée entre les deux vis 11 associées à un module 2 donné.

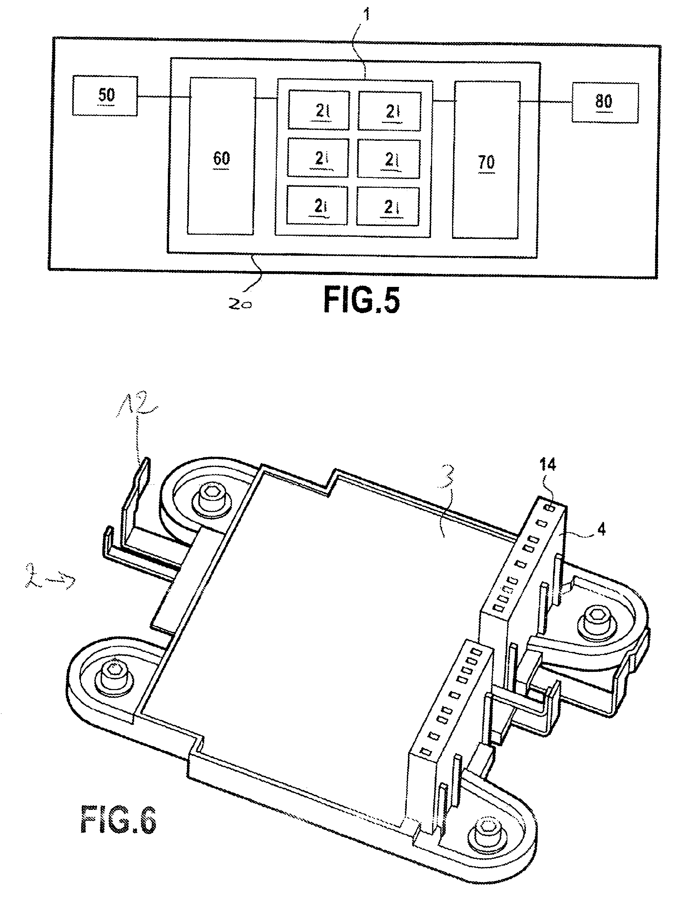

A la figure 6, il est représenté un exemple de module 2. Ce module 2 peut notamment être un module IML comme décrit dans le brevet français N° 0116153 au nom de la demanderesse.

Par exemple, le module 2 comprend un boîtier 3 dans lequel sont reçues des lames 12 conductrices, par exemple en cuivre, sur lesquelles sont montés des composants 16 électroniques de puissance (figure 4).

Les composants 16 peuvent être montés, notamment brasés ou soudés, sur les lames conductrices 12. Les composants 16 peuvent être par exemple un composant bipolaire tel qu'une diode, un composant tripolaire tel qu'un transistor de type MOS ou IGBT ou un composant plus complexe tel q'un circuit intégré de type ASIC ou analogues.

De préférence, le module 2 comprend un connecteur 4 permettant de relier électriquement les composants 16 du module 2 à des signaux de commande, notamment à la carte 6 électronique de commande.

Par exemple, le connecteur est un plot 4 de connexion issu de la face supérieure du boîtier 3 et qui comporte des points 14 de connexion, par exemple à la carte 6 électronique 6 de commande.

De préférence, les lames conductrices 12 font saillie de part et d'autre des modules 2 pour la connexion à un réseau de puissance et/ou aux autres modules. Les lames conductrices 12 sont séparées les unes des autres par une matière diélectrique 15 isolante.

Par exemple, l'espace intérieur du boîtier 3 est empli d'un gel, tel que du silicone, pour la protection des composants 16 de puissance. A la place du gel, on peut prévoir d'autres matériaux analogues, par exemple une résine de type époxy.

Comme représenté à la figure 5, le bloc électronique 21 de puissance peut faire partie, avec deux blocs 60, 70 de filtrage, d'un onduleur 20 destiné à être disposé entre une batterie 50 à haute tension d'un véhicule électrique et une prise 80 de secteur pour la recharge de la batterie 50.

En particulier, le bloc de puissance 21 peut avoir une longueur de 30 cm et une largeur de 25 cm, et chaque module 2 a une longueur et une largeur de 10 cm.

## Revendications

1. Bloc de puissance ayant un carter (1) dans lequel est reçu au moins un module électronique (2) de puissance, de préférence une pluralité de modules (2) de puissance, positionné sur un plan du carter (1), le ou chaque module (2) électronique de puissance comportant au moins un composant (16) électronique de puissance, et étant connecté à au moins une carte (6) électronique de commande par l'intermédiaire d'au moins un élément de connexion (5), ledit bloc comprenant au moins un organe (7, 8) supportant la au moins une carte électronique de commande en vis-à-vis du module (2) de puissance sur au moins une étendue de la carte (6), et **caractérisé en ce que** l'organe de support est une poutre (7, 8) sensiblement parallèle audit plan du carter.

2. Bloc de puissance suivant la revendication 1, **caractérisé en ce que** l'élément de connexion (5) est soudé à la carte de commande (6) par ultrason.

3. Bloc de puissance suivant la revendication 1 ou 2, **caractérisé en ce que** l'élément de connexion (5) entre le au moins un module (2) de puissance et la au moins une carte électronique (6) de commande est constitué d'au moins un fil de liaison électrique.

4. Bloc de puissance suivant l'une des revendications précédentes, **caractérisé en ce que** l'organe de support (7, 8) est fixé au carter (1) du bloc de puissance.

5. Bloc de puissance suivant la revendication 4, **caractérisé en ce que** l'organe (7, 8) est supporté par une ou des parois latérales du carter (1).

6. Bloc de puissance suivant l'une des revendications précédentes, **caractérisé en ce que** la carte électronique (6) de commande est fixée à l'organe de support (7, 8) par au moins un organe de fixation (11), de préférence une vis de fixation.

7. Bloc de puissance suivant la revendication 6, **caractérisé en ce qu'**il comprend deux organes de fixation (11) en vis-à-vis du module (2) de puissance.

8. Bloc de puissance suivant la revendication 7, **caractérisé en ce que** l'élément de connexion (5) connecte la carte (6) entre lesdits deux organes de fixation (11).

9. Bloc de puissance suivant l'une des revendications précédentes, **caractérisé en ce que** l'organe (7, 8) de support comprend une première matière rigide (8) s'étendant dans l'organe de support.

10. Bloc de puissance selon la revendication 9, **caractérisé en ce que** une seconde matière (19) isolante électriquement recouvre au moins une partie de ladite première matière rigide (18).

11. Bloc de puissance selon la revendication 10 **caractérisé en ce que** la seconde matière (19) est surmoulée sur la première matière (18).

12. Bloc de puissance selon la revendication 10 ou 11, **caractérisé en ce que** l'organe de fixation (11) pénètre dans un trou (13) formé dans la première matière (18) de l'organe de support (8), le trou (13) étant rempli de la seconde matière (19) électriquement isolante (10).

13. Bloc de puissance suivant l'une des revendications précédentes, **caractérisé en ce que** la flèche de l'organe de support (7, 8) est inférieure à 0,1 mm lorsque l'organe de support subit une contrainte transverse comprise entre 1 et 2 kg et est soumis à des ultrasons compris entre 50 et 100 KHz.

14. Onduleur (20), notamment pour un véhicule électrique, comportant un bloc de puissance suivant l'une des revendications précédentes.

15. Véhicule électrique comportant un bloc de puissance (21) suivant l'une des revendications 1 à 13 relié à une batterie haute tension (50) du véhicule électrique en vue de recharger la batterie à partir d'une prise (80) d'un secteur électrique.

## Patentansprüche

1. Leistungsblock, der ein Gehäuse (1) aufweist, in dem mindestens ein elektronisches Leistungsmodul (2), vorzugsweise mehrere Leistungsmodule (2) aufgenommen ist/sind, das/die auf einer Ebene des Gehäuses (1) positioniert ist/sind, wobei das oder jedes elektronische Leistungsmodul (2) mindestens ein elektronisches Leistungsbauelement (16) aufweist, und über mindestens ein Verbindungselement (5) mit mindestens einer elektronischen Steuerkarte (6) verbunden ist, wobei der Block mindestens ein Organ (7, 8) umfasst, das die mindestens eine elektronische Steuerkarte gegenüber dem Leistungsmodul (2) über mindestens eine Ausdehnung der Karte (6) stützt und **dadurch gekennzeichnet, dass** das Stützorgan ein Träger (7, 8) ist, der im Wesentlichen parallel zur Ebene des Gehäuses ist.

2. Leistungsblock nach Anspruch 1, **dadurch gekennzeichnet, dass** das Verbindungselement (5) per Ultraschall an die Steuerkarte (6) geschweißt ist.

3. Leistungsblock nach Anspruch 1 oder 2, **dadurch gekennzeichnet, dass** das Verbindungselement (5) zwischen dem mindestens einen Leistungsmodul (2) und der mindestens einen elektronischen Steuerkarte (6) aus mindestens einem elektrischen Verbindungsdraht besteht.

4. Leistungsblock nach einem der vorhergehenden Ansprüche, **dadurch gekennzeichnet, dass** das Stützorgan (7, 8) am Gehäuse (1) des Leistungsblocks befestigt ist.

5. Leistungsblock nach Anspruch 4, **dadurch gekennzeichnet, dass** das Organ (7, 8) durch eine oder mehrere Seitenwände des Gehäuses (1) gestützt wird.

6. Leistungsblock nach einem der vorhergehenden Ansprüche, **dadurch gekennzeichnet, dass** die elektronische Steuerkarte (6) durch mindestens ein Befestigungsorgan (11), vorzugsweise eine Befestigungsschraube, an dem Stützorgan (7, 8) befestigt ist.

7. Leistungsblock nach Anspruch 6, **dadurch gekennzeichnet, dass** er zwei dem Leistungsmodul (2) gegenüberliegende Befestigungsorgane (11) aufweist.

8. Leistungsblock nach Anspruch 7, **dadurch gekennzeichnet, dass** das Verbindungselement (5) die Karte (6) zwischen den zwei Befestigungsorganen (11) verbindet.

9. Leistungsblock nach einem der vorhergehenden Ansprüche, **dadurch gekennzeichnet, dass** das Stützorgan (7, 8) ein erstes steifes Material (18) aufweist, das sich in dem Stützorgan erstreckt.

10. Leistungsblock nach Anspruch 9, **dadurch gekennzeichnet, dass** ein zweites, elektrisch isolierendes Material (19) mindestens einen Teil des ersten, starren Materials (18) bedeckt.

11. Leistungsblock nach Anspruch 10, **dadurch gekennzeichnet, dass** das zweite Material (19) auf dem ersten Material (18) nach einem Gussstück geformt ist.

12. Leistungsblock nach Anspruch 10 oder 11, **dadurch gekennzeichnet, dass** das Befestigungsorgan (11) in ein Loch (13) eindringt, das in dem ersten Material (18) des Stützorgans (8) gebildet ist, wobei das Loch (13) mit dem zweiten (19), elektrisch isolierenden Material (10) gefüllt ist.

13. Leistungsblock nach einem der vorhergehenden Ansprüche, **dadurch gekennzeichnet, dass** die Durchbiegung des Stützorgans (7, 8) kleiner als 0,1 mm ist, wenn das Stützorgan eine Querbeanspruchung erfährt, die zwischen 1 und 2 kg liegt, und Ultraschallwellen ausgesetzt wird, die zwischen 50 und 100 KHz liegen.

14. Wechselstromumrichter (20), insbesondere für ein elektrisches Fahrzeug, das einen Leistungsblock nach einem der vorhergehenden Ansprüche aufweist.

15. Elektrisches Fahrzeug, das einen Leistungsblock (21) nach einem der Ansprüche 1 bis 13 aufweist, der mit einer Hochspannungsbatterie (50) des elektrischen Fahrzeugs zum Wiederaufladen der Batterie ausgehend von einer Steckdose (80) eines Stromnetzes verbunden ist.

## Claims

1. Power unit having a casing (1) in which is received at least one electronic power module (2), preferably a plurality of power modules (2), positioned on a plane of the casing (1), the or each electronic power module (2) comprising at least one electronic power component (16), and being connected to at least one electronic control board (6) via at least one connection element (5), said unit comprising at least one member (7, 8) supporting the at least one electronic control board facing the power module (2) on at least one extent of the board (6), and **characterized in that** the support member is a beam (7, 8) substantially parallel to said plane of the casing.

2. Power unit according to Claim 1, **characterized in that** the connection element (5) is welded to the control board (6) by ultrasound.

3. Power unit according to Claim 1 or 2, **characterized in that** the connection element (5) between the at least one power module (2) and the at least one electronic control board (6) consists of at least one electrical link wire.

4. Power unit according to one of the preceding claims, **characterized in that** the support member (7, 8) is fixed to the casing (1) of the power unit.

5. Power unit according to Claim 4, **characterized in that** the member (7, 8) is supported by one or more side walls of the casing (1).

6. Power unit according to one of the preceding claims, **characterized in that** the electronic control board (6) is fixed to the support member (7, 8) by at least one fixing member (11), preferably a fixing screw.

7. Power unit according to Claim 6, **characterized in that** it comprises two fixing members (11) facing the power module (2).

8. Power unit according to Claim 7, **characterized in that** the connection element (5) connects the board (6) between said two fixing members (11).

9. Power unit according to one of the preceding claims, **characterized in that** the support member (7, 8) comprises a first rigid material (18) extending in the support member.

10. Power unit according to Claim 9, **characterized in that** a second electrically insulating material (19) covers at least a part of said first rigid material (18).

11. Power unit according to Claim 10, **characterized in that** the second material (19) is overmoulded on the first material (18).

12. Power unit according to Claim 10 or 11, **characterized in that** the fixing member (11) penetrates into a hole (13) formed in the first material (18) of the support member (8), the hole (13) being filled with the second material (19) that is electrically insulating (10).

13. Power unit according to one of the preceding claims, **characterized in that** the bow of the support member (7, 8) is less than 0.1 mm when the support member undergoes a transverse stress of between 1 and 2 kg and is subjected to ultrasound of between 50 and 100 KHz.

14. Inverter (20), notably for an electric vehicle, comprising a power unit according to one of the preceding claims.

15. Electric vehicle comprising a power unit (21) according to one of Claims 1 to 13 linked to a high-voltage battery (50) of the electric vehicle in order to recharge the battery from an electrical mains outlet (80).
